# EUROPEAN PATENT SPECIFICATION

(11) **EP 3 503 201 B1**
(45) Date of publication and mention of the grant of the patent: **27.04.2022**
(21) Application number: 17210286.5
(22) Date of filing: 22.12.2017
(51) Int. Cl.: H01L 29/66, H01L 29/78, H01L 29/786, H01L 29/423

(54) **A METHOD FOR FORMING A VERTICAL CHANNEL DEVICE**
VERFAHREN ZUR FORMUNG EINER VERTIKALKANALVORRICHTUNG
PROCÉDÉ DE FORMATION D'UN DISPOSITIF À CANAL VERTICAL

(43) Date of publication of application: 26.06.2019
(73) Proprietor: IMEC vzw, 3001 Leuven (BE)
(72) Inventor: CHAN, Boon Teik, 3001 Leuven (BE); VELOSO, Anabela, 3001 Leuven (BE); ALTAMIRANO SANCHEZ, Efrain, 3001 Leuven (BE); TAO, Zheng, 3001 Leuven (BE)
(74) Representative: AWA Sweden AB

(56) References cited:
- EP-A1- 3 153 463
- R LEGTENBERG ET AL: "Anisotropic reactive ion etching of silicon using SF6/O2/CHF3 gas mixtures", JOURNAL OF THE ELECTROCHEMICAL SOCIETY, vol. 142, no. 6, 6 June 1995 (1995-06-06), pages 2020-2028, XP055482682,

## Description

### Technical field

The present inventive concept relates to a method for forming a vertical channel device.

### Background

Driven by the desire to produce even more power efficient semiconductor devices and area efficient circuit designs, new semiconductor devices are being developed. One promising type of devices is vertical channel transistor devices. A vertical channel transistor device may include a vertically oriented semiconductor structure and a gate extending vertically along the semiconductor structure. One example of a vertical channel transistor device is the vertical gate-all-around field effect transistor (GAAFET). Providing a vertical channel device with good electrostatic properties and at the same

time a low series resistance is however challenging.

EP 3 153 463 A1 describes a method for forming a vertical channel device.

Legtenberg et al., in "Anisotropic Reactive Ion Etching of Silicon Using SF6/O2/CHF3", J. Electrochem. Soc., Vol 142 (1995), No. 6, pages 2020-2028 describes the use of fluorine-, oxygen- and carbon-containing gas in etching tapered profiles in silicon.

### Summary

An objective of the present inventive concept is to address this challenge. Further objectives may be understood from the following.

According to an aspect of the present inventive concept there is provided a method for forming a vertical channel device, the method comprising:
forming a vertical semiconductor structure including an upper portion, an intermediate portion and a lower portion, by etching a semiconductor layer stack arranged on a substrate, the semiconductor layer stack including an upper semiconductor layer, an intermediate semiconductor layer and a lower semiconductor layer, wherein the intermediate semiconductor layer is formed of a material different from a material of the lower semiconductor layer and different from a material of the upper semiconductor layer,
wherein the forming of the vertical semiconductor structure comprises:
   etching the upper semiconductor layer to form said upper portion and the intermediate semiconductor layer to form said intermediate portion,
   detecting whether said etching has reached the lower semiconductor layer, and
   in response to detecting that said etching has reached the lower semiconductor layer, changing to a modified etching chemistry being different from an etching chemistry used during said etching of the intermediate semiconductor layer, and etching the lower semiconductor layer using the modified etching chemistry to form said lower portion, wherein the modified etching chemistry is such that the lower portion is formed to present, along at least a part of said lower portion, a lateral dimension gradually increasing along a direction towards the substrate,
and the method further comprising:
   forming a gate stack extending vertically along the intermediate portion to define a channel region of the vertical channel device.

The inventive method enables forming of a vertical channel device presenting good electrostatic properties and at the same time a low series resistance. As realized by the inventors, conventional methods of forming a vertical channel device with a thin channel (i.e. a channel of a small lateral dimension or small horizontal cross-section) tend to result in a thin lower portion (defining e.g. a source or drain of the vertical channel device) as well. This may have an adverse impact on the series resistance of the device due to a reduced contact area towards an underlying connection region such as a bottom electrode region. Meanwhile, forming a vertical channel device with a wider lower source/drain portion (i.e. a greater lateral dimension) tends to result in a wide channel portion as well, which may have an adverse impact on the electrostatics of the device. The present method provides control over a profile during the etching of the layer stack such that a vertical semiconductor structure may be formed with an intermediate portion with a targeted (advantageously small) lateral dimension and a lower portion with an increasing lateral dimension along a downward direction (a "tapering" along an upward direction), and thus providing an increased contact area.

Furthermore, detecting whether the etching of the intermediate layer has reached the lower layer enables an advantageous degree of control of when to change to the modified etching chemistry. Thus, modified etching chemistry may be selectively applied to the lower layer and the lower portion.

The detecting may be performed by optical emission spectroscopy during the etching.

As used herein, the term "vertical" (e.g. with reference to an extension, a direction or a plane) denotes an extension/direction/plane being parallel to a vertical geometrical axis extending perpendicular to the substrate (i.e. perpendicular to a main plane of extension or main surface of the substrate). The terms "above", "upper", "top" and "below", "lower", "bottom" may accordingly be used to refer to relative positions along the vertical axis. The terms "downward" and "upward" may be used to refer to vertical directions towards and away from, respectively, the main surface of the substrate. The term "horizontal" may correspondingly denote a direction/extension/plane being perpendicular to the vertical geometrical axis.

The term "lateral dimension" (e.g. of a feature such as the lower portion) denotes a dimension along a direction perpendicular to the vertical geometrical axis (i.e. along a horizontal direction).

A lower portion is formed to present, along at least a part of said lower portion, a lateral dimension gradually increasing along a direction towards the substrate. More specifically, the lower portion may be formed to present, along at least a part of said lower portion, an increasing cross sectional area along a direction towards the substrate. Thereby, a bottom part of the lower portion may present a greater cross sectional area than a top part of the lower portion.

By vertical channel device is hereby meant a device, preferably a transistor, having a channel oriented vertically with respect to the substrate. An orientation of the channel may here refer to the direction of the flow of charge carriers through the channel, during use of the device. The transistor may advantageously be a field-effect transistor (FET).

According to the invention, the afore-mentioned etching chemistries are dry etching chemistries each including a fluoride-including component and a carbon-including component, wherein a fluoride-to-carbon-ratio in the modified etching chemistry is smaller than a fluoride-to-carbon-ratio in the etching chemistry used during said etching of the intermediate semiconductor layer.

Dry etching chemistries allow anisotropic etching of the semiconductor layer stack in the vertical direction. A high-aspect ratio vertical semiconductor structure may thus be formed. Moreover, as realized by the inventors, having a modified etch chemistry with a fluoride-to-carbon-ratio which is smaller than that of the etching chemistry used during the etching of the intermediate layer, enables forming of the lower portion with a tapering. This may be attributed to a lower relative amount of fluoride compared to carbon during etching of the lower layer resulting in a more efficient surface passivation with respect to fluoride-etchants (e.g. a thicker passivation layer may form on the sidewall of the pillar being formed). The passivation may in turn result in a tapering during the etching.

Hence, a fluoride-to-carbon ratio during the etching of the lower layer may be controlled such that the gradually increasing lateral dimension is obtained for the lower portion.

For at least one of the etching chemistries, the fluoride-including component may advantageously be SF₆ and the carbon-including component may be a fluorocarbon (CₓF₂ₓ such as CF₄ or C₂F₄) or CHₓF_{y} (such as CH₂F₂). These compounds allow efficient etching of semiconductor layers, in particular group IV semiconductors such as Si, Ge or SiGe, with control of the profile via the ratios of the components. CFₓ or CHₓF_{y} may result in a forming of a polymerization layer on the etched sidewalls which may reduced the fluoride-etch, wherein the etching may result in a tapering.

The lower semiconductor layer may advantageously be etched with an etch chemistry where the ratio of SF₆ to CH₂F₂ is equal to or less than 1:1.2. This enables forming of a lower portion with a profile with a comparably uniform slope. Alternatively, the lower semiconductor layer may be etched with an etch chemistry where the ratio of SF₆ to CF₄ is equal to or less than 1:9. This also allows forming the lower portion to present a tapering.

The upper semiconductor layer may be etched with an etch chemistry where the ratio of SF₆ to CF₄ is in the range of 1:3 to 1:8, or greater than 1:3. Alternatively, upper semiconductor layer may be etched with an etch chemistry where the ratio of SF₆ to CH₂F₂ is in the range of 1:0.8 to 1:1.1, or greater than 1:0.8.

The intermediate semiconductor layer may be etched with an etch chemistry where the ratio of SF₆ to CF₄ is in the range of 1:3 to 1:8, or greater than 1:3. Alternatively, the intermediate semiconductor layer may be etched with an etch chemistry where the ratio of SF₆ to CH₂F₂ is in the range of 1:0.8 to 1:1.1, or greater than 1:0.8. Thereby, the upper portion and the intermediate portion may be formed to present a lateral dimension being more or less constant, or decreasing along a direction towards the substrate.

The upper semiconductor layer and the intermediate semiconductor layer may be etched using a same etching chemistry or different etching chemistries. By this the cross section of the upper portion and the intermediate portion can either be made with similar profile, by using the same etch chemistry, or different profiles, by using different etch chemistries.

According to one embodiment, a maximum lateral dimension of the intermediate portion is smaller than a maximum of said lateral dimension of the lower portion. This may contribute to improved electrostatics and a low series resistance.

According to one embodiment, the lower semiconductor layer has a greater Ge-content than the intermediate semiconductor layer.

Alternatively or additionally, the upper semiconductor layer may have a greater Ge-content than the intermediate semiconductor layer.

According to one embodiment, the lower semiconductor layer includes Si and Ge, the intermediate layer includes Si, and the upper semiconductor layer includes Si and Ge. A layer stack of these materials allows forming of a vertical semiconductor device with a Si-based channel and SiGe-based lower and upper source/drain portions. The lateral etch rate of these materials are sensitive to different ratios of fluoride to carbon in etching chemistries. This will allow for a lateral dimension of structures dry etched from these materials to be controlled by varying the ratio fluoride to carbon.

According to one embodiment, said upper portion and said lower portion are formed of SiGe and said intermediate portion is formed of Si.

By including these materials, a vertical semiconductor device can be made where a channel can be made from the intermediate layer and a source and a drain can be made from the upper and lower layers. The lateral dry etch rate of these materials are sensitive to the fluoride-to-carbon-ratio of the etching chemistry (e.g. different ratios of SF₆ to CH₂F₂ or SF₆ to CF₄).

According to one embodiment the method further comprises:
subsequent to forming said upper portion, and prior to forming said intermediate portion, forming a spacer layer on sidewalls of said upper portion, and
subsequent to forming said spacer layer, performing said etching of the intermediate semiconductor layer to form said intermediate portion.

The upper portion may thereby be masked from the etching chemistries used during etching of the intermediate portion. Hence, a risk of the etching of the intermediate portion reducing a lateral dimension of the upper portion may be mitigated. This in turn allows forming of the upper portion being wider than the intermediate portion. The spacer layer may protect the upper portion both during the etch of the intermediate portion as well as during subsequent etching, such as during the etching of the lower portion.

The method may further comprise:
subsequent to forming said intermediate portion, reducing a lateral dimension of the intermediate portion by etching the intermediate portion, wherein said spacer layer counteracts etching of the upper portion. A selective "thinning" of the intermediate portion is thus allowed wherein the spacer layer counteracts a simultaneous thinning of the upper portion.

Alternatively or additionally, selective thinning of the intermediate portion may be achieved by:
subsequent to forming said intermediate portion, reducing a lateral dimension of the intermediate portion by oxidizing the intermediate portion, wherein said spacer layer counteracts oxidation of the upper portion.

The intermediate semiconductor layer may advantageously be formed by a material presenting a greater oxidation rate than a material forming the lower semiconductor layer (and optionally also than a material forming the upper semiconductor layer). One such layer stack is a layer stack including a SiGe intermediate layer with a greater Ge content than the upper and the lower semiconductor layers, each of which may be a SiGe-layer or a Si-layer.

According to one embodiment, forming the gate stack includes forming a gate conductor enclosing the intermediate portion. A gate-all-around vertical channel device may thereby be formed.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figures 1 to 5 illustrate a method for forming a vertical channel device.
Figures 6 and 7 illustrate a variation of a method for forming a vertical channel device.

### Detailed description

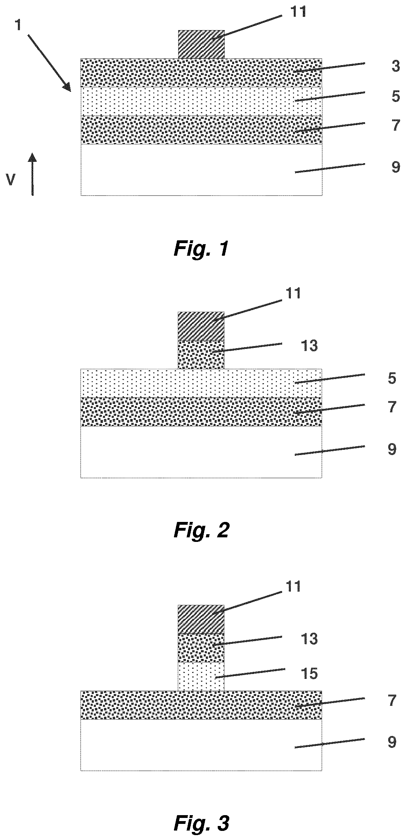

Figure 1 illustrates a cross sectional view of a semiconductor layer stack 1 on a substrate 9. It should be noted that the layer stack 1 and the substrate 9 may extend laterally or horizontally beyond the illustrated portion. Although in the following, forming of a single vertical channel device will be described and illustrated it should be noted that a plurality of such devices may be formed in parallel. It should further be noted that the relative dimensions of the shown elements, in particular the relative thickness of the layers, is merely schematic and may, for the purpose of illustrational clarity, differ from a physical structure.

The substrate 9 may be a semiconductor substrate, such as of a group IV semiconductor material. The substrate 9 may for instance be a silicon (Si) substrate, a germanium (Ge) substrate or a silicon-germanium (SiGe) substrate. The substrate 9 may also be of a multi-layered configuration, such as a silicon-on-insulator (SOI) substrate, a Ge on insulator (GeOI) substrate or a SiGeOI substrate.

The layer stack 1 includes in a top-down direction (i.e. opposite to the vertical direction V indicated in figure 1) an upper semiconductor layer 3, an intermediate semiconductor layer 5 and a lower semiconductor layer 7. The upper layer 3 is formed on the intermediate layer 5. The intermediate layer 5 is formed on the lower layer 7. The lower layer 7 is formed on a main surface of the substrate 9.

Each one of the layers 3, 5, 7 of the layer stack 1 may be formed of a different semiconductor material. At least the intermediate layer 5 may be formed of a material different from a material of the upper layer 3 and different from a material of the lower layer 7. Each one of the layers 3, 5, 7 may be a layer of a respective group IV semiconductor (elemental or compound).

The upper layer 3 and the lower layer 7 may each be a SiGe-layer with a Ge content in the range of 10 % to 90 % and the intermediate layer 5 may be a Si-including layer with a smaller Ge content than the upper layer 3 and the lower layer 7. By way of example, the upper layer 3 and the lower layer 7 may each have a Ge content of about 25 % and the intermediate layer 5 may be a layer consisting of, or at least substantially consisting of, Si. However, it is also possible to form the upper layer 3 and the lower layer 7 as layers Si- or SiGe-layers and the intermediate layer 5 as a SiGe-layer having a greater Ge-content than the upper layer 3 and the lower layer 7.

The layers 3, 5, 7 may be layers grown by a respective epitaxial process, for instance by chemical vapor deposition (CVD) or physical vapor deposition (PVD). Each one of the layer 3, 5, 7 may be formed with a respective thickness on the order of a few tens of nm. As non-limiting examples, a thickness of the upper layer 3 may be in the range of 40-70 nm, a thickness of the intermediate layer 5 may be in the range of 40-70 nm, and a thickness of the lower layer 7 may be in the range of 50-100 nm.

The upper layer 3 and the lower layer 7 may each be doped with an nor p-type dopant to allow forming of source/drain regions of the vertical channel device of the intended type. The intermediate layer 5 may be lightly doped by a dopant of an opposite type to that of the upper layer 3 and the lower layer 7, or be un-doped.

As shown in figure 1, a mask 11 is formed above the layer stack 1. The mask 11 may be formed on the upper layer 3. The mask 11 may be defined with a circular or oval shape wherein a pillar- or column-shaped vertical semiconductor structure with a corresponding cross-sectional shape may be formed. However, the mask 11 may also be defined with a rectangular or generally polygonal shape. The mask 11 may be a single-layer mask such as a resist-based mask, a carbon-based hard mask, an advanced patterning film (APF) or a multi-layered mask including a stack of sub-layers, such as a conventional lithographic layer stack. The mask 11 may defined in a single patterning process such as a single litho-etch process, or using a multiple patterning process such as a multi litho-etch process (e.g. (litho-etch)x).

Figures 2 through 4 illustrate forming of a vertical semiconductor structure including an upper portion 13, an intermediate portion 15 and a lower portion 17, by etching the layer stack 1. In figure 2 an upper portion 13 has been formed from the upper layer 3 by etching the upper layer 3 in regions exposed by the mask 11. In figure 3 an intermediate portion 15 has been formed from the intermediate layer 5 by etching the intermediate layer 5 in regions exposed by the etch mask 11 (and the upper portion 13). The intermediate portion 15 is formed directly below the upper portion 13. In other words, the intermediate portion 15 is vertically aligned with the upper portion 13.

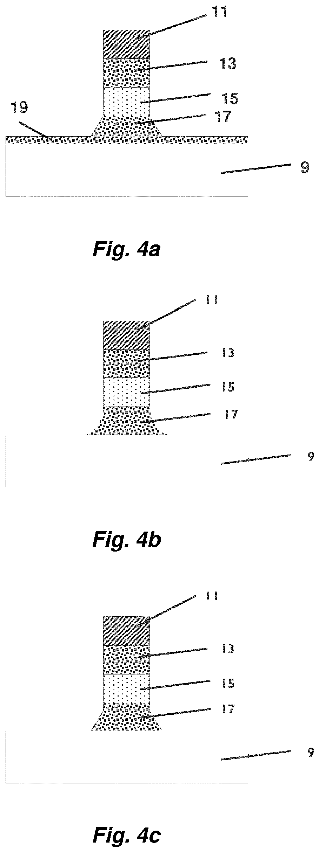

In Figure 4a a lower portion 17 has been formed from the lower layer 7 by etching the lower layer 17 in regions exposed by the mask 11 (and the intermediate and upper portions 15, 13). The lower portion 17 is formed directly below the intermediate portion 15. The lower portion 17 is vertically aligned with the intermediate portion 15 and the upper portion 13. The lower portion 17 is formed to present, along at least a part of the lower portion 17, a lateral dimension which is gradually increasing along a direction towards the substrate 9. As shown in Figure 4a the lower portion 17 may accordingly be formed with a tapering along vertical direction away from the substrate 9. The lower portion 17 may as shown be formed such that the maximum lateral dimension of the intermediate portion 15 is smaller than the maximum lateral dimension of the lower portion 17. The intermediate portion 15 (as well as the upper portion 13) may as shown be formed with a relatively straight profile. For example, the sidewalls of the intermediate portion 15 (and the upper portion 13) may extend at an angle of 90° ±5° with respect to the main surface of the substrate 9.

The upper layer 3 and the intermediate layer 5 may both be etched using a first etching chemistry. The lower layer 7 is etched using a modified second etching chemistry, i.e. an etching chemistry being different from the first etch chemistry. Hence, rather than etching the layer stack 1 in a single step, i.e. with a constant etching chemistry, the etching of the layer stack 1 may include two steps, i.e. with two different etching chemistries.

During the etching, optical emission spectroscopy of gases resulting during the etching may be performed. An emission spectra may be measured using a spectrometer of the etching tool. At some point during the etching of the intermediate layer 5 the lower layer 7 will be exposed wherein etching of the lower layer 7 will commence. This will, due to the different material compositions of the intermediate layer 5 and the lower layer 7, result in an altered emission spectra which in turn may be used as an indicator or a trigger to end etching with the first etching chemistry and initiate etching with the modified second etching chemistry. In response to detecting that the etch process for forming the intermediate portion 15 has etched through the intermediate layer 5 (i.e. detection of an end-point for the first etching step) and reached the lower layer 7 the etching chemistry is changed to the (modified) second etching chemistry. The change may be made directly in response to detecting the end-point. However, it is also possible to continue etching for some duration before changing to the modified second etch chemistry a tapering is desired along only a part of the lower portion. It may further be noted that even if the end-point detection is used to directly trigger the change of etching chemistry (i.e. stopping the first etching process step, evacuating the reaction and then initiating the second etching process step) it may take a few seconds to obtain a stable gas mixture and/or reach sufficient pressure to obtain plasma ignition.

The etching process for etching the vertical semiconductor structure may be a dry etching process. The etching process may be performed using a reactive ion etching (RIE) tool, for instance employing an inductively coupled plasma (ICP) or a capacitively coupled plasma (CCP). Each one of the first etching chemistry and the second etching chemistry may be a dry etching chemistry (e.g. a gas plasma), each including a fluoride-including component (F) and a carbon-including component (C) wherein a fluoride-to-carbon-ratio in the second etching chemistry is smaller than a fluoride-to-carbon-ratio in the first etching chemistry. That is, the content of carbon in relation to fluoride may be greater in the second chemistry than in the first etching chemistry.

The first etching chemistry may be a gas mixture of SF₆ as a first component and CF₄ as a second component (optionally supplemented with N₂ as a third component). The second etching chemistry may also be a gas mixture of the same components, i.e. SF₆ and CF₄ (optionally supplemented with N₂), but having a ratio of SF₆ to CF₄ which is smaller than a ratio of SF₆ to CF₄ of the first etching chemistry. The first etching chemistry may have a ratio of SF₆ to CF₄ in the range of about 1:4 to 1:8. Thereby the upper portion 13 and the intermediate portion 15 may be formed with a uniform cross section (at least substantially uniform). Alternatively, the first etching chemistry may have a ratio of SF₆ to CF₄ being equal to or greater than about 1:3. Thereby the upper portion 13 and the intermediate portion 15 may be formed with a gradually decreasing cross section along a vertical direction towards the substrate 9. The second etching chemistry may have a (modified) ratio of SF₆ to CF₄ being equal to or less than about 1:9. Thereby the lower portion 17 may be formed with a gradually increasing cross section along a vertical direction towards the substrate 9.

CF₄ as the second component of the first etching chemistry and/or the second component of the second etching chemistry may be substituted by another carbon-including component such as CH₂F₂. Accordingly, the first etching chemistry may have a ratio of SF₆ to CH₂F₂ in the range of about 1:0.9 to 1:1.1 to form the upper portion and the intermediate portion 15 with a uniform cross section (at least substantially uniform). Alternatively, the first etching chemistry may have a ratio of SF₆ to CH₂F₂ equal to or greater than about 1:0.8 to form the upper portion 13 and the intermediate portion 15 with a gradually decreasing cross section along a vertical direction towards the substrate 9. The second etching chemistry may also or alternatively have a (modified) ratio of SF₆ to CH₂F₂ equal to or less than about 1:1.2. An SF₆ to CH₂F₂ ratio in this range allows forming of a lower portion 17 with a profile with a comparably uniform slope as shown in figure 4a.

Further gas mixtures of the first and the second etching chemistry are also possible. For instance, one of the first and the second etching chemistry may include CF₄ and the other etching chemistry may include CH₂F₂ as the second component. According to a further alternative, one of the first and the second etching chemistry, or both the first and the second etching chemistry, may include C₄F₈ as the second component instead of CF₄ or CH₂F₂. Further examples of CHₓF_{y} chemistries are CHF₃ and CH₃F.

Although in figure 4a the lower portion 17 is shown to present a rather constant increasing lateral dimension this only represents one option. Figure 4b shows an alternative wherein the curvature of the lower portion 17 varies along the vertical dimension of the lower portion 17. A varying curvature may be achieved by varying the fluoride-to-carbon ratio during the etching of the lower layer 7. Figure 4c shows a further alternative wherein the change to the modified second etching chemistry has been delayed compared to the case in figure 4a. Hence the etching with the first etching chemistry has progressed by some distance into the lower layer 7.

As shown figure 4a, the etching process may be stopped before etching completely through the lower layer 7. The remaining thickness portion of the lower layer 7 may form a connection region or bottom electrode region 19 extending under the lower portion 17. A bottom electrode region may however also be formed in other ways. For example, a corresponding bottom electrode region may be formed by a heavily doped semiconductor region of the substrate 9, the doped region extending underneath the lower portion 17. In this case the etching may be stopped when the substrate 9 is exposed (which for instance may be detected via the emission spectra in the etching tool). In any case, the profile of the lower portion 17 enables an increased contact area with respect to an underlying conductive region, such as bottom electrode region 19. Subsequent to completing the etching process the mask 11 may be removed from the upper portion 13.

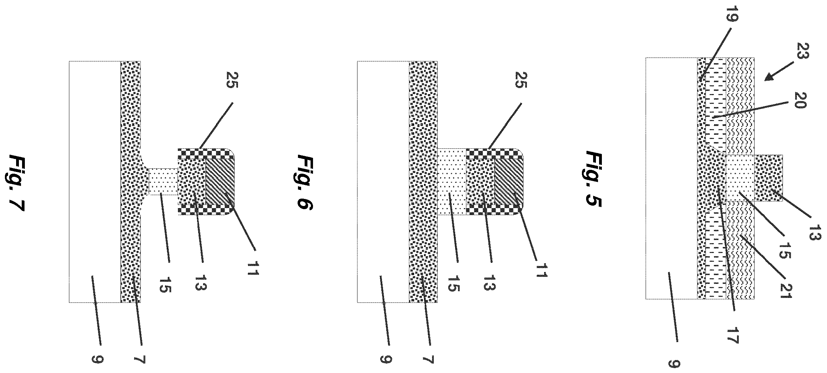

Figure 5 shows the vertical channel device 23. A gate stack 21 has been formed around the intermediate portion 15, enclosing the intermediate portion 15. The gate stack 21 may as shown be formed on a bottom insulating layer 20 which has been deposited to embed the lower portion 17 (and cover the bottom electrode region 19 if present, or substrate 9). The bottom insulating layer 20 may accordingly insulate the gate stack 21 from below layers. A channel region of the device 23 may extend vertically in the intermediate portion 15 being enclosed by the gate stack 21. Accordingly, respective source/drain regions of the device 23 may be defined in the upper portion 13 and the lower portion 17, on opposite sides of the channel region. The gate stack 21 may be formed by depositing a gate dielectric layer on the sidewalls of the vertical channel structure and subsequently depositing a conductive gate layer embedding the intermediate portion 15. The lateral dimensions of the gate layer may be defined by patterning the gate layer using techniques which per se are known in the art. A gate stack 21 may also be formed using a replacement metal gate process (RMG), wherein a dummy gate structure may be replaced by a replacement gate structure using conventional processing techniques.

Figure 6-7 schematically illustrate additional processing steps according to a variation of the above method. With reference to figure 6, subsequent to forming the upper portion 13, the etching process may be temporarily halted and a spacer 25 may be formed on the sidewalls of the upper portion 13 (and of the mask 11). The spacer 25 may be formed by depositing a conformal spacer layer on the structure and thereafter vertically etching the conformal spacer layer to remove the conformal spacer layer from horizontally oriented surfaces, thereby leaving the spacer 25 on the sidewalls. The spacers may be formed by a dielectric material, such as Si₃N4, SiO₂, SiOC, SiCO, SiON, Al₂O₃ or HfO₂. However a metal-based spacer material is also possible such as AIN or TiN.

Following forming of the spacer 25, the etching process may be resumed wherein etching of the intermediate layer 5 may be performed to form the intermediate portion 15. Subsequently the lower layer 7 may be etched to form the lower portion 17, as described above. During the etching of the spacer 25 may counteract lateral etching of the upper portion 13. Following the etching of the layer stack 1 the spacer 25 may be removed and the method may proceed as described in connection with figure 5 above.

Alternatively, an optional thinning of the intermediate portion 15 may be performed as illustrated in figure 7. The intermediate portion 15 may be thinned by oxidation or by wet etching, for instance a diluted HF-based etch. During the thinning, the spacer 25 may counteract thinning of the upper portion 13 (although as shown a lowermost surface of the upper layer 13 may still be slightly affected by the thinning process). In figure 7 the thinning is shown to be performed prior to forming the lower portion 17 however it is also possible to perform the thinning subsequent to forming the lower portion 17 provided some loss of cross-sectional dimension of the lower portion 17 is acceptable.

In the above the inventive concept has mainly been described with reference to a limited number of examples. However, as is readily appreciated by a person skilled in the art, other examples than the ones disclosed above are equally possible within the scope of the inventive concept, as defined by the appended claims.

For instance, although in the above a same "first" etching chemistry is used for etching the upper and the intermediate layers 3, 5 it is also possible to use different etching chemistries during etching of the upper and the intermediate layers 3, 5. I.e. a first etching chemistry may be used for etching the upper layer 3, a second etching chemistry (different from the first) may be used for etching the intermediate layer 5 and a third etching chemistry (different from the second and the first etching chemistries) may be used for etching the lower layer 7 in the manner described above. For instance, the first etching chemistry may be chosen to form the upper portion 13 with a gradually decreasing cross section (in a direction towards the substrate 9) while the second etching chemistry may be chosen to form the intermediate portion 15 with a uniform cross section. The change from the first etching chemistry to the second etching chemistry may be performed in response to detecting (e.g. via the emission spectra) that the etching of the upper layer 3 has reached the intermediate layer 5.

## Claims

1. A method for forming a vertical channel device, the method comprising:
forming a vertical semiconductor structure including an upper portion (13), an intermediate portion (15) and a lower portion (17), by etching a semiconductor layer stack arranged on a substrate (9), the semiconductor layer stack including an upper semiconductor layer (3), an intermediate semiconductor layer (5) and a lower semiconductor layer (7), wherein the intermediate semiconductor layer (5) is formed of a material different from a material of the lower semiconductor layer (7) and different from a material of the upper semiconductor layer, layer (3),
wherein the forming of the vertical semiconductor structure comprises:
etching the upper semiconductor layer (3) to form said upper portion (13) and the intermediate semiconductor layer (5) to form said intermediate portion (15),
detecting whether said etching has reached the lower semiconductor layer (7), and
in response to detecting that said etching has reached the lower semiconductor layer (7), changing to a modified etching chemistry being different from an etching chemistry used during said etching of the intermediate semiconductor layer (5), and etching the lower semiconductor layer (7) using the modified etching chemistry to form said lower portion (17), wherein the modified etching chemistry is such that the lower portion (17) is formed to present, along at least a part of said lower portion (17), a lateral dimension gradually increasing along a direction towards the substrate (9),
wherein said etching chemistries are dry etching chemistries each including a fluoride-including component and a carbon-including component, wherein a fluoride-to-carbon-ratio in the modified etching chemistry is smaller than a fluoride-to-carbon-ratio in the etching chemistry used during said etching of the intermediate semiconductor layer (5),
and the method further comprising:
forming a gate stack (21) extending vertically along the intermediate portion (15) to define a channel region of the vertical channel device.

2. A method according to claim 1, wherein the fluoride-including component is SF₆ and the carbon-including component is a fluorocarbon, preferably CF₄ or C₂F₄, or CHₓF_{y}, preferably CH₂F₂.

3. A method according to claim 2, wherein the lower semiconductor layer (7) is etched with an etch chemistry where the ratio of SF₆ to CH₂F₂ is equal to or less than 1:1.2.

4. A method according to any of the preceding claims, wherein a maximum lateral dimension of the intermediate portion (15) is smaller than a maximum of said lateral dimension of the lower portion (17).

5. A method according to any of the preceding claims, wherein the lower semiconductor layer (7) has a greater Ge-content than the intermediate semiconductor layer (5).

6. A method according to claim 5, wherein the upper semiconductor layer has a greater Ge-content than the intermediate semiconductor layer (5).

7. A method according to claim 6, wherein the lower semiconductor layer (7) includes Si and Ge, the intermediate layer (5) includes Si, and the upper semiconductor layer (3) includes Si and Ge.

8. A method according to any of the preceding claims, further comprising:
subsequent to forming said upper portion (13),
and prior to forming said intermediate portion (15), forming a spacer layer (25) on sidewalls of said upper
portion (13), and
subsequent to forming said spacer layer (25), performing said etching of the intermediate semiconductor layer (5) to form said intermediate portion (15).

9. A method according to claim 8, further comprising:
subsequent to forming said intermediate portion (15), reducing a lateral dimension of the intermediate portion (15) by etching the intermediate portion (15), wherein said spacer layer (25) counteracts etching of the upper portion (13).

10. A method according to any of claims 8-9, further comprising:
subsequent to forming said intermediate portion (15), reducing a lateral dimension of the intermediate portion (15) by oxidizing the intermediate portion (15), wherein said spacer layer (25) counteracts oxidation of the upper portion (13).

11. A method according to claim 10, wherein a material forming the intermediate semiconductor layer (5) presents a greater oxidation rate than a material forming the lower semiconductor layer (7).

12. A method according to any of the preceding claims, wherein forming the gate stack (21) includes forming a gate conductor enclosing the intermediate portion.

## Patentansprüche

1. Verfahren zum Bilden einer Vertikalkanalvorrichtung, wobei das Verfahren umfasst:
Bilden einer vertikalen Halbleiterstruktur, die einen oberen Abschnitt (13), einen mittleren Abschnitt (15) und einen unteren Abschnitt (17) umfasst, durch Ätzen eines Halbleiter-Schichtstapels, der auf einem Substrat (9) angeordnet ist, wobei der Halbleiter-Schichtstapel eine obere Halbleiterschicht (3), eine mittlere Halbleiterschicht (5) und eine untere Halbleiterschicht (7) umfasst, wobei die mittlere Halbeiterschicht (5) aus einem Material gebildet ist, das anders als ein Material der unteren Halbeiterschicht (7) und anders als ein Material der oberen Halbeiterschicht (3) ist,
wobei das Bilden der vertikalen Halbleiterstruktur umfasst:
Ätzen der oberen Halbeiterschicht (3), um den oberen Abschnitt (13) zu bilden, und der mittleren Halbeiterschicht (5), um den mittleren Abschnitt (15) zu bilden,
Detektieren, ob das Ätzen die untere Halbleiterschicht (7) erreicht hat, und als Reaktion darauf, dass das Ätzen die untere Halbleiterschicht (7) erreicht hat, Wechseln auf eine modifizierte Chemikalie, die anders als eine Ätzchemikalie ist, die während des Ätzens der mittleren Halbleiterschicht (5) verwendet wird, und
Ätzen der unteren Halbeiterschicht (7) unter Verwendung der modifizierten Ätzchemikalie, um den unteren Abschnitt (17) zu bilden, wobei die modifizierte Ätzchemikalie derart ist, dass der untere Abschnitt (17) gebildet wird, um entlang mindestens eines Teils des unteren Abschnitts (17) eine seitliche Dimension aufzuweisen, die entlang einer Richtung zum Substrat (9) hin allmählich zunimmt,
wobei die Ätzchemikalien Trockenätzchemikalien sind, die jeweils eine fluoridhaltige Komponente und eine kohlenstoffhaltige Komponente umfassen, wobei ein Fluorid-Kohlenstoff-Verhältnis in der modifizierten Ätzchemikalie kleiner ist als ein Fluorid-Kohlenstoff-Verhältnis in der Ätzchemikalie, die während des Ätzens der mittleren Halbeiterschicht (5) verwendet wird,
und wobei das Verfahren ferner umfasst:
Bilden eines Gate-Stapels (21), der sich vertikal entlang des mittleren Abschnitts (15) erstreckt, um eine Kanalregion der Vertikalkanalvorrichtung zu definieren.

2. Verfahren nach Anspruch 1, wobei die fluoridhaltige Komponente SF₆ ist und die kohlenstoffhaltige Komponente ein Fluorkohlenstoff, bevorzugt CF₄ oder C₂F₄, oder CHₓF_{y}, bevorzugt CH₂F₂, ist.

3. Verfahren nach Anspruch 2, wobei die untere Halbeiterschicht (7) mit einer Ätzchemikalie geätzt wird, bei der das Verhältnis von SF₆ zu CH₂F₂ gleich oder kleiner als 1:1,2 ist.

4. Verfahren nach einem der vorhergehenden Ansprüche, wobei eine maximale seitliche Dimension des mittleren Abschnitts (15) kleiner als ein Maximum der seitlichen Dimension des unteren Abschnitts (17) ist.

5. Verfahren nach einem der vorhergehenden Ansprüche, wobei die untere Halbeiterschicht (7) einen größeren Ge-Gehalt als die mittlere Halbeiterschicht (5) aufweist.

6. Verfahren nach Anspruch 5, wobei die obere Halbeiterschicht (3) einen größeren Ge-Gehalt als die mittlere Halbleiterschicht (5) aufweist.

7. Verfahren nach Anspruch 6, wobei die untere Halbeiterschicht (7) Si und Ge umfasst, die mittlere Schicht (5) Si umfasst, und die obere Halbeiterschicht (3) Si und Ge umfasst.

8. Verfahren nach einem der vorhergehenden Ansprüche, ferner umfassend:
nach dem Bilden des oberen Abschnitts (13) und vor dem Bilden des mittleren Abschnitts (15), Bilden einer Zwischenschicht (25) auf den Seitenwänden des oberen Abschnitts (13), und
nach dem Bilden der Zwischenschicht (25), Ausführen des Ätzens der mittleren Halbeiterschicht (5), um den mittleren Abschnitt (15) zu bilden.

9. Verfahren nach Anspruch 8, ferner umfassend:
nach dem Bilden des mittleren Abschnitts (15), Reduzieren einer seitlichen Dimension des mittleren Abschnitts (15) durch Ätzen des mittleren Abschnitts (15), wobei die Zwischenschicht (25) dem Ätzen des oberen Abschnitts (13) entgegenwirkt.

10. Verfahren nach einem der Ansprüche 8 bis 9, ferner umfassend:
nach dem Bilden des mittleren Abschnitts (15), Reduzieren einer seitlichen Dimension des mittleren Abschnitts (15) durch Oxidieren des mittleren Abschnitts (15), wobei die Zwischenschicht (25) der Oxidation des oberen Abschnitts (13) entgegenwirkt.

11. Verfahren nach Anspruch 10, wobei ein Material, das die mittlere Halbeiterschicht (5) bildet, eine größere Oxidationsrate aufweist als ein Material, das die untere Halbleiterschicht (7) bildet.

12. Verfahren nach einem der vorhergehenden Ansprüche, wobei das Bilden des Gate-Stapels (21) das Bilden eines Gate-Leiters umfasst, der den mittleren Abschnitt einschließt.

## Revendications

1. Procédé de formation d'un dispositif à canal vertical, le procédé comprenant :
la formation d'une structure semi-conductrice verticale comprenant une partie supérieure (13), une partie intermédiaire (15), et une partie inférieure (17), par gravure d'un empilement de couches semi-conductrices disposé sur un substrat (9), l'empilement de couches semi-conductrices comprenant une couche semi-conductrice supérieure (3), une couche semi-conductrice intermédiaire (5), et une couche semi-conductrice inférieure (7),
dans lequel la couche semi-conductrice intermédiaire (5) est formée par un matériau différent d'un matériau de la couche semi-conductrice inférieure (7) et différent d'un matériau de la couche semi-conductrice supérieure (3),
dans lequel la formation de la structure semi-conductrice verticale comprend :
la gravure de la couche semi-conductrice supérieure (3) pour former ladite partie supérieure (13) et de la couche semi-conductrice intermédiaire (5) pour former ladite partie intermédiaire (15),
la détection si ladite gravure a atteint la couche semi-conductrice inférieure (7) et, en réponse à la détection que ladite gravure a atteint la couche semi-conductrice inférieure (7), le passage à un produit chimique de gravure modifié qui est différent d'un produit chimique de gravure utilisé pendant ladite gravure de la couche semi-conductrice intermédiaire (5), et la gravure de la couche semi-conductrice inférieure (7) en utilisant le produit chimique de gravure modifié pour former ladite partie inférieure (17), dans lequel le produit chimique de gravure modifié est tel, que la partie inférieure (17) est formée pour présenter, le long d'au moins une partie de ladite partie inférieure (17), une dimension latérale augmentant progressivement le long d'une direction vers le substrat (9),
dans lequel lesdits produits chimiques de gravure sont des produits chimiques de gravure sèche comprenant chacun un composant comprenant du fluorure et un composant comprenant du carbone, dans lequel un rapport fluorure-carbone dans le produit chimique de gravure modifié est inférieur à un rapport de fluorure-carbone dans le produit chimique de gravure utilisé pendant ladite gravure de la couche semi-conductrice intermédiaire (5),
et le procédé comprenant en outre :
la formation d'un empilement de grille (21) s'étendant verticalement le long de la partie intermédiaire (15) pour définir une région de canal du dispositif à canal vertical.

2. Procédé selon la revendication 1, dans lequel le composant comprenant du fluorure est du SF₆ et le composant comprenant du carbone est un fluorocarbone, de préférence du CF₄ ou C₂F₄, ou du CHₓF_{y}, de préférence du CH₂F₂.

3. Procédé selon la revendication 2, dans lequel la couche semi-conductrice inférieure (7) est gravée avec un produit chimique de gravure où le rapport entre SF₆ et CH₂F₂ est inférieur ou égal à 1:1,2.

4. Procédé selon l'une quelconque des revendications précédentes, dans lequel une dimension latérale maximale de la partie intermédiaire (15) est inférieure à un maximum de ladite dimension latérale de la partie inférieure (17).

5. Procédé selon l'une quelconque des revendications précédentes, dans lequel la couche semi-conductrice inférieure (7) a une teneur en Ge supérieure à la couche semi-conductrice intermédiaire (5).

6. Procédé selon la revendication 5, dans lequel la couche semi-conductrice supérieure (3) a une teneur en Ge supérieure à la couche semi-conductrice intermédiaire (5).

7. Procédé selon la revendication 6, dans lequel la couche semi-conductrice inférieure (7) comprend du Si et Ge, la couche intermédiaire (5) comprend du Si, et la couche semi-conductrice supérieure (3) comprend du Si et Ge.

8. Procédé selon l'une quelconque des revendications précédentes, comprenant en outre :
après la formation de ladite partie supérieure (13) et avant la formation de ladite partie intermédiaire (15), la formation d'une couche d'espacement (25) sur des parois latérales de ladite partie supérieure (13), et
après la formation de ladite couche d'espacement (25), la réalisation de ladite gravure de la couche semi-conductrice intermédiaire (5) pour former ladite partie intermédiaire (15).

9. Procédé selon la revendication 8, comprenant en outre :
après la formation de ladite partie intermédiaire (15), la réduction d'une dimension latérale de la partie intermédiaire (15) par gravure de la partie intermédiaire (15),
dans lequel ladite couche d'espacement (25) agit à l'encontre de la gravure de la partie supérieure (13).

10. Procédé selon l'une quelconque des revendications 8-9, comprenant en outre :
après la formation de ladite partie intermédiaire (15), la réduction d'une dimension latérale de la partie intermédiaire (15) par oxydation de la partie intermédiaire (15),
dans lequel ladite couche d'espacement (25) agit à l'encontre de l'oxydation de la partie supérieure (13).

11. Procédé selon la revendication 10, dans lequel un matériau formant la couche semi-conductrice intermédiaire (5) présente une vitesse d'oxydation supérieure à un matériau formant la couche semi-conductrice inférieure (7).

12. Procédé selon l'une quelconque des revendications précédentes, dans lequel la formation de l'empilement de grille (21) comprend la formation d'un conducteur de grille entourant la partie intermédiaire.
